Europäisches Patentamt

European Patent Office

Office européen des brevets

(11) Veröffentlichungsnummer: **0 207 323 B1**

## (12) EUROPÄISCHE PATENTSCHRIFT

(45) Veröffentlichungstag der Patentschrift: **11.09.91**

(51) Int. Cl.⁵: **G01R 25/00**, G01R 25/08, H03L 7/08, H03D 13/00

(21) Anmeldenummer: **86107701.4**

(22) Anmeldetag: **06.06.86**

(54) Phasensynchronismus-Detektor.

(30) Priorität: **03.07.85 DE 3523713**

(43) Veröffentlichungstag der Anmeldung:
**07.01.87 Patentblatt 87/02**

(45) Bekanntmachung des Hinweises auf die
Patenterteilung:
**11.09.91 Patentblatt 91/37**

(84) Benannte Vertragsstaaten:
**FR GB IT**

(56) Entgegenhaltungen:
**EP-A- 0 168 584**
**DE-A- 3 245 438**
**US-A- 3 328 688**
**US-A- 3 597 636**

**PATENT ABSTRACTS OF JAPAN, Band 5, Nr. 198 (E-87)[870], 16. Dezember 1981; & JP-A-56 122 521 (TOKYO SHIBAURA DENKI K.K.) 26-09-1981**

(73) Patentinhaber: **ANT Nachrichtentechnik GmbH**
**Gerberstrasse 33**
**W-7150 Backnang(DE)**

(72) Erfinder: **Annecke, Karl-Heinz, Dr.**
**Irisstrasse 28**
**W-8038 Gröbenzell(DE)**
Erfinder: **Hegny, Helmut, Dipl.-Ing.**
**Stuttgarter Strasse 89**
**W-7150 Backnang(DE)**

## Beschreibung

Die Erfindung betrifft eine Schaltungsanordnung zum Detektieren einer Phasensynchronität zweier verschiedener Signale mittels zweier Speicher, auf deren jeweiligen Signal- und Takteingäng eines der beiden Signale geführt ist, wobei die beiden Speicher eine Haltezeit Null aufweisen, wobei dem Takteingang des ersten Speichers das erste Signal T1 und seinem Daten-Eingang das zweite Signal T2 und dem Takteingang des zweiten Speichers das zweite Signal T2 und seinem Dateneingang das erste Signal T1 zugeführt ist, wobei eine Logikschaltung vorgesehen ist, welcher als Eingangssignale einerseits die beiden Signale T1, T2 und andererseits die Ausgangssignale Q1, Q2 oder die invertierten Ausgangssignale $\overline{Q1}$, $\overline{Q2}$ der Speicher zugeführt sind und welche ein Ausgangssignal Y erzeugt nach der logischen Gleichung

$$Y = Q1 + Q2 + \overline{T1} + \overline{T2} \text{ oder}$$
$$Y = \overline{Q1} \cdot \overline{Q2} \cdot T1 \cdot T2, \text{ und}$$

wobei dieses Ausgangssignal Y dann einen Impuls aufweist, wenn die Flanken der beiden Signale T1, T2 zeitlich zusammenfallen.

Eine derartige Schaltungsanordnung ist aus der EP-A-0 168 584 (relevant gemäß Artikel 54(3) EPÜ) bekannt.

Eine solche Schaltungsanordnung findet Anwendung auf den verschiedensten Gebieten der elektrischen Nachrichtenübertragung bzw. -verarbeitung, beispielsweise bei der Übergabe von Informationen zwischen zwei Systemen mit plesiochronen Takten oder bei einer Empfangsschaltung zur Synchronisation des Multiplexübertragungsrahmens.

Durch die US-Patentschrift 3,328,688 ist ein Phasenkomparator mit bistabilen und logischen Elementen bekannt geworden, wobei jeweils über einen Inverter bzw. direkt das eine Eingangssignal auf die Setzeingänge und das andere Eingangssignal auf die Rücksetzeingänge zweier pegelgesteuerter RS-Flip-Flops gelegt sind und wobei jeweils deren Normalausgänge und deren invertierte Ausgänge mit den beiden Eingängen eines UND- oder NOR-Gliedes verbunden sind und wobei die Differenz der beiden Ausgangssignale mit anschließender Integration gebildet wird. Die Schaltung vermag Phasendifferenzen zwischen ± 180° anzuzeigen, sofern die beiden Eingangssignale gleiches Tastverhältnis aufweisen.

Der Erfindung lag die Aufgabe zugrunde, eine Schaltung der eingangs genannten Art anzugeben, die mit hoher Sicherheit den Flankensynchronismus zweier unterschiedlicher Signale oder das zeitliche Zusammenfallen dieser Signalflanken innerhalb eines Toleranzbereiches zu erkennnen vermag und ein Alarm- oder Steuersignal daraus abzuleiten im Stande ist.

Die Schaltungsanordnung soll so aufgebaut sein, daß sie wenig Aufwand erfordert.

Die Lösung erfolgt mit den in dem Patentanspruch 1 definierten Merkmalen. Die Schaltungsanordnung weist einen geringen Schaltungsaufwand auf und erfüllt die Voraussetzungen für Schaltungsintegration.

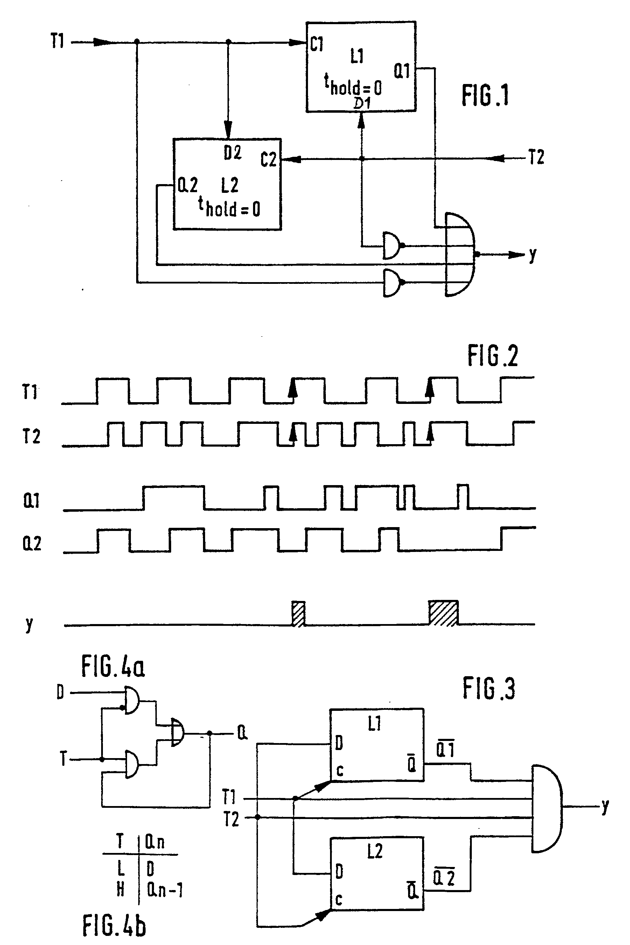

Es folgt die Beschreibung der Schaltungsanordnung anhand der Figuren. Die Figur 1 zeigt einen Phasensynchronismus-Detektor, die Figur 2 den zeitlichen Verlauf einiger Signale an wichtigen Punkten dieses Detektors und die Figur 3 schließlich eine weitere Anordnung mit noch geringerem Schaltungsaufwand. In Figur 4a ist der interne Aufbau eines in den Anordnungen der Fig. 1 und 3 verwendeten Latchs und in Fig. 4b seine Wahrheitstabelle dargestellt.

In Figur 1 sind zwei Speicher L1 und L2 mit der Haltezeit $t_{Hold} = O$ erkennbar, ihren Takteingängen wird jeweils eines der beiden Signale T1 bzw. T2 und ihren D-Eingängen jeweils das andere Signal T2, T1 der beiden Signale zugeführt. Die Ausgangssignale Q1, Q2 der Speicher werden einem NOR-Glied zugeführt, dessen beide anderen Eingänge über zwei Inverter mit den beiden Signalen T1 und T2 versorgt werden. Am Ausgang des NOR-Gliedes ist ein Ausgangssignal Y abgreifbar, das bei Eintritt des Flankensynchronismus der beiden Signale T1 und T2 einen Impuls von der Länge des kürzeren Signales abgibt.

In Figur 2 ist dies erkennbar, hier sind über der Zeit aufgetragen zuoberst die Signale T1 und T2 mit unterschiedlichen Taktperioden und unterschiedlichem Phasenverlauf. Darunter sind die zeitlichen Verläufe der Ausgangssignale Q1 und Q2 der beiden Speicher gezeichnet, und zuunterst ist das Ausgangssignal Y aufgetragen.

Hierbei wurden die Setzzeiten der Speicher nicht berücksichtigt (praktische Werte bei Ausführung in CMOS-/TTL-Technik etwa 10 ns, in ECL-Technik etwa 700 ps). Fällt ein Flankenwechsel des einen Signals, das als Datensignal des einen Speichers benutzt wird, in die Setzzeit dieses Speichers, d.h. kommt die Flanke des anderen Signales innerhalb dieser Zeit, so ist das Verhalten dieses Speichers unbestimmt. Wird er rückgesetzt oder bleibt er nicht gesetzt, so wird "Flankensynchronismus" signalisiert. Der Fehler kann in diesem Falle also einen Wert annehmen, der kleiner als die längste Setzzeit der beiden Speicher ist, wobei man im allgemeinen davon ausgehen kann, daß die beiden Setzzeiten bei Realisierung der Schaltung in Hochintegrationstechnik weitgehend übereinstimmen.

Die Figur 3 zeigt eine aufwandsgünstigere Schaltungsanordnung, wobei außer den beiden Speichern ein einziges UND-Glied mit vier Eingängen verwendet wird. Zwei dieser Eingänge werden mit den beiden Signalen T1 und T2 beaufschlagt, während die beiden anderen Eingänge mit den invertierten Ausgangssignalen $\overline{Q1}$ und $\overline{Q2}$ der beiden Speicher, welche eingangsseitig genauso wie in Figur 1 beschaltet sind, beaufschlagt werden. Am Ausgang des UND-Gliedes ist ebenfalls das Ausgangssignal Y abgreifbar. Der Vorteil der Anordnung nach Fig. 3 liegt in der Anwendung bei höheren Taktfrequenzen, da die einzelnen Signalpfade annähernd die gleichen Verzögerungszeiten aufweisen. Ein weiterer Vorteil dieser Anordnung gegenüber derjenigen nach Figur 1 besteht darin, daß die Flankensynchronität um die längste Verzögerungszeit der Inverter früher angezeigt wird.

Sehr aufwandgünstig ist es, als Speicher Latches zu verwenden, die mit 3 Verknüpfungsgliedern zu realisieren sind (siehe logisches Blockschaltbild der Figur 4a), während bei Verwendung eines D-Flip-Flops 6 Verknüpfungsglieder aufgewendet werden müssen.

**Patentansprüche**

1. Schaltungsanordnung Zum Detektieren einer Phasensynchronität zweier verschiedener Signale mittels zweier Speicher, auf deren jeweiligen Signal- und Takteingäng eines der beiden Signale geführt ist, wobei die beiden Speicher eine Haltezeit ($t_{hold}$) Null aufweisen, wobei dem Takteingang (C1) des ersten Speichers (L1) das erste Signal T1 und seinem Daten-Eingang (D1) das zweite Signal T2 und dem Takteingang (C2) des zweiten Speichers (L2) das zweite Signal T2 und seinem Dateneingang (D2) das erste Signal T1 zugeführt ist, wobei eine Logikschaltung vorgesehen ist, welcher als Eingangssignale einerseits die beiden Signale T1, T2 und andererseits die Ausgangssignale Q1, Q2 oder die invertierten Ausgangssignale $\overline{Q1}$, $\overline{Q2}$ der Speicher (L1, L2) zugeführt sind und welche ein Ausgangssignal Y erzeugt nach der logischen Gleichung

$$Y = Q1 + Q2 + \overline{T1} + \overline{T2} \text{ oder}$$
$$Y = \overline{Q1} \cdot \overline{Q2} \cdot T1 \cdot T2, \text{ und}$$

wobei dieses Ausgangssignal Y dann einen Impuls aufweist, wenn die Flanken der beiden Signale T1, T2 zeitlich zusammenfallen, wobei die Speicher Latches (L1, L2) sind, die den an ihren Dateneingang (D) angelegten Signalpegel an ihren Ausgang als Ausgangssignal Q durchlassen, wenn der an ihren Takteingang (T, C) angelegte Signalpegel einen bestimmten Wert unterschreitet (L), und den Ausgangszustand speichern $Q_n = Q_{n-1}$, wenn der an ihren Takteingang (T, C) angelegte Signalpegel einen bestimmten Wert überschreitet (H).

2. Schaltungsanordnung nach Anspruch 1, wobei die Logikschaltung ein NOR = GLied mit vier Eingängen und zwei Inverter enthält, wobei die nicht invertierten Ausgänge der beiden Speicher (L1, L2) jeweils mit einem Eingang des NOR-Gliedes verbunden sind, wobei dessen beiden anderen Eingängen jeweils über einen der Inverter das erste Signal T1 bzw. das zweite Signal T2 zugeführt ist und wobei am Ausgang des NOR-Gliedes das Ausgangssignal Y abgreifbar ist.

3. Schaltungsanordnung nach Anspruch 1, wobei die Logikschaltung ein UND-Glied mit vier Eingängen enthält, wobei die invertierten Ausgänge der Speicher (L1, L2) jeweils mit einem dieser vier Eingänge verbunden sind und den anderen beiden Eingängen jeweils das erste Signal T1 bzw. das zweite Signal T2 zugeführt ist und wobei am Ausgang des UND-Gliedes das Ausgangssignal Y abgreifbar ist.

**Claims**

1. Circuit arrangement for the detection of a phase synchronism of two different signals by means of two stores, on the respective signal and pulse input of each of which one of both the signals is carried, wherein both the stores display a holding time ($t_{hold}$) of zero, wherein the first signal T1 is fed to the pulse input (C1) of the first store (L1) and the second signal T2 is fed to its data input (D1) and the second signal T2 is fed to the pulse input (C2) of the second store (L2) and the first signal T1 is fed to its data input (D2), wherein a logic circuit is provided, to which on the one hand both the signals T1 and T2 and on the other hand the output signals Q1 and Q2 or the inverted output signals $\overline{Q1}$ and $\overline{Q2}$ of the stores (L1, L2) are fed as input signals and which produces an output signal according to the logic equation
$Y = Q1 + Q2 + \overline{T1} + \overline{T2}$ or $Y = \overline{Q1} \cdot \overline{Q2} \cdot T1 \cdot T2$,
and wherein this output signal Y displays a pulse when the edges of both the signals T1 and T2 co-incide in time, wherein the stores are latches (L1, L2), which let the signal level applied at their data input (D) through as output signal Q at their output when the signal level applied at their pulse input (T, C) falls below a certain value (L) and which store the output state $Q_n = Q_{n-1}$ when the signal level applied at their pulse input (T, C) exceeds a certain value (H).

2. Circuit arrangement according to claim 1, wherein the logic circuit contains a NOR-member with four inputs and two inverters, wherein the non-inverted outputs of both the stores (L1, L2) are each connected with a respective input of the NOR-member, wherein the first signal T1 and the second signal T2 are each fed by way of a respective one of the inverters to a respective one of both its other inputs and wherein the output signal Y is derivable at the output of the NOR-member.

3. Circuit arrangement according to claim 1, wherein the logic circuit contains an AND-member with four inputs, wherein the inverted outputs of the stores (L1, L2) are each connected with a respective one of these four inputs and the first signal T1 and the second signal T2 are each fed to a respective one of both the other inputs and wherein the output signal Y is derivable at the output of the AND-member.

**Revendications**

1. Agencement de circuit pour détester un synchronisme de phase de deux signaux différents au moyen de deux mémoires aux entrées de signal et d'horloge desquelles est amené à chaque fois l'un des deux signaux, les deux mémoires présentant un temps de maintien ($t_{hold}$) nul, l'entrée d'horloge (C1) de la première mémoire (L1) recevant le premier signal T1 et son entrée de données (D1) recevant le deuxième signal T2, et l'entrée d'horloge (C2) de la deuxième mémoire (L2) recevant le deuxième signal T2 et son entrée de données (D2) recevant le premier signal T1, un circuit logique étant prévu auquel on envoie, en tant que signaux d'entrée, d'une part les deux signaux T1, T2 et, d'autre part, les signaux de sortie Q1, Q2 ou les signaux de sortie inversés $\overline{Q1}$, $\overline{Q2}$ des mémoires (L1, L2), ce circuit logique produisant un signal de sortie selon l'équation logique
Y = Q1 + Q2 + $\overline{T1}$ + $\overline{T2}$ ou
Y = $\overline{Q1}$ · $\overline{Q2}$ · T1 · T2, et
ce signal de sortie présentant alors une impulsion si les flancs des deux signaux T1, T2 coïncident dans le temps, les mémoires étant des Latches (L1, L2) qui laissent le niveau de signal appliqué à leur entrée de données (D) sortir à leur sortie en tant que signal de sortie Q si le niveau de signal appliqué à leur entrée d'horloge (T, C) passe en dessous d'une valeur déterminée (L), et mémorisent l'état de sortie $Q_n = Q_{n-1}$ si le niveau de signal appliqué à leur entrée d'horloge (T, C) passe au-dessus d'une valeur déterminée (H).

2. Agencement de circuit selon revendication 1, le circuit logique comportant un élément NOR à quatre entrées et deux inverseurs, les sorties non inversées des deux mémoires (L1, L2) étant reliées à chaque fois à une entrée de l'élément NOR aux deux autres entrées duquel sont amenés, à chaque fois par l'intermédiaire d'un inverseur, le premier signal T1 et respectivement le deuxième signal T2, et le signal de sortie Y pouvant être prélevé à la sortie de l'élément NOR.

3. Agencement de circuit selon revendication 1, le circuit logique contenant un élément ET à quatre entrées, les sorties inversées des mémoires (L1, L2) étant reliées à chaque fois à l'une de ces quatre entrées, le premier signal T1 et le deuxième signal T2 étant respectivement amenés aux deux autres entrées, et le signal de sortie Y pouvant être prélevé à la sortie de l'élément ET.

FIG.1

FIG.2

FIG.4a

FIG.3

| T | $Q_n$ |
|---|---|
| L | D |
| H | $Q_{n-1}$ |

FIG.4b